# EUROPÄISCHE PATENTSCHRIFT

(11) **EP 0 929 952 B1**
(45) Veröffentlichungstag und Bekanntmachung des Hinweises auf die Patenterteilung: **19.05.2004**
(21) Anmeldenummer: 97925759.9
(22) Anmeldetag: 24.09.1997
(51) Int. Cl.: H04B 10/145, H03L 7/26

(54) **ERZEUGUNG EINES OPTISCHEN FREQUENZREFERENZSIGNALS**
PRODUCTION OF AN OPTICAL FREQUENCY REFERENCE SIGNAL
PRODUCTION D'UN SIGNAL OPTIQUE DE REFERENCE DE FREQUENCE

(30) Priorität: 30.09.1996 DE 19640292
(43) Veröffentlichungstag der Anmeldung: 21.07.1999
(73) Patentinhaber: SIEMENS AKTIENGESELLSCHAFT, 80333 München (DE)
(72) Erfinder: BISCHOFF, Mathias, D-81375 München (DE)
(86) Internationale Anmeldenummer: PCT/DE1997/002170
(87) Internationale Veröffentlichungsnummer: WO 1998/015074

(56) Entgegenhaltungen:
- US-A- 4 926 429
- GUY M ET AL: "SIMULTANEOUS ABSOLUTE FREQUENCY CONTROL OF LASER TRANSMITTERS IN BOTH 1.3 AND 1.55 MUM BANDS FOR MULTIWAVELENGTH COMMUNICATION SYSTEMS" JOURNAL OF LIGHTWAVE TECHNOLOGY, Bd. 14, Nr. 6, 1.Juni 1996, Seiten 1136-1143, XP000598519
- MIAO ZHU ET AL: "SHORT AND LONG TERM STABILITY OF OPTICAL OSCILLATORS" PROCEEDINGS OF THE FREQUENCY CONTROL SYMPOSIUM, HERSHEY, MAY 27 - 29, 1992, Nr. -, 27.Mai 1992, INSTITUTE OF ELECTRICAL AND ELECTRONICS ENGINEERS, Seiten 44-55, XP000341333
- MADEJ A A ET AL: "ABSOLUTE HETERODYNE FREQUENCY MEASUREMENT OF THE 88SR+ 455-THZ S-D SINGLE ION TRANSITION" OPTICS LETTERS, Bd. 21, Nr. 11, 1.Juni 1996, Seiten 824-826, XP000594894

## Beschreibung

Die Erfindung betrifft ein Verfahren zur Erzeugung eines Frequenzreferenzsignals entsprechend dem Oberbegriff des Anspruchs 1 und eine Anordnung zur Durchführung des Verfahrens.

Der ständig steigende Bandbreitebedarf in der Telekommunikation kann im Kernnetz durch die Anwendung von Wellenlängenmultiplex befriedigt werden. Diese Technik erlaubt eine bessere Ausnutzung der inhärenten Übertragungsbandbreite von auf Quarzglas basierenden Lichtwellenleitern als die heute übliche Einkanalübertragung. Voraussetzung für eine erfolgreiche Anwendung der Wellenlängenmultiplextechnik sind Lichtquellen, die mit hoher Genauigkeit auf einer vorgegebenen Frequenz ihr Licht emittieren und optische Filter, deren Übertragungsfunktion dem gewählten Kanalraster angepaßt ist. Da die Eigenschaften sowohl von als Lichtquellen verwendeten Laserdioden als auch von geeigneten optischen Filtern temperaturabhängig sind und außerdem Alterungsprozessen unterliegen, ist eine Überwachung der Frequenzgenauigkeit und bei den hohen Anforderungen der Wellenlängenmultiplextechnik eine. Regelung der Emissionsfrequenz von Laserdioden bzw. der Bandmittenfrequenz des optischen Filters erforderlich. Im Hinblick auf die hohe Genauigkeit an die Frequenzreferenz werden dafür atomare Übergänge bzw. Molekülresonanzen insbesondere des Kryptonisotops 84, von Ammoniak, Azetylen, Blausäure verwendet, die aus "Standardization of optical frequencies for WDM networking applications" SPIE - Int. Soc. Opt. Eng., Chung, Y.C.; Clark, L.; Fan, C. Laser Frequency Stabilization and Noise Reduction 1995, San Jose, Seiten 230-235 bekannt sind. Als besonders geeignet für den Aufbau einer Frequenzreferenz im dritten optischen Fenster, also bei 1550 nm wird dort der Übergang zwischen 1s² und 2p⁸ des Kryptonisotops 84 betrachtet, der einer Frequenz von 193,68622 THz entspricht.

In "Absorption spectra of excited Kr84 states between 1.5 and 1.58µm and their use for absolute frequency locking" J. Lightwave Techn. Fischer, U.H.P.; v. Helmolt, C.; 14(1996), 139-143 ist eine Anordnung beschrieben, bei der der kollimierte Strahl einer Laserdiode LD1 durch ein mit dem Kryptonisotop 84 gefülltem Galvanotron gerichtet wird, das über einen Widerstand mit einer Hochspannungsquelle verbunden ist. Die Laserdiode wird dabei mit einem Signal kleiner Amplitude und niedriger Frequenz moduliert, wodurch sich am Widerstand ein hierzu synchrones Signal ergibt, aus welchem mittels Synchrondetektion ein Regelsignal abgeleitet wird, das die Emissionsfrequenz der Laserdiode auf den Wert des atomaren Übergangs einregelt, wodurch ein erstes Referenzsignal erzeugt wird. Nun ergibt sich aber das Problem, daß dieses Referenzsignal nicht in das von der ITU-T empfohlene Kanalraster paßt.

Weitere Literaturstellen beschreiben den allgemeinen Stand der Technik. So ist aus "Simultaneous Absolute Frequency Control of Laser Transmitters in both 1.3 and 1.55 µm Bands for Multiwavelength Communication Systems" von M. Guy, B. Villeneuve, Ch. Latrasse und M. Têtu, Journal of Lightwave Technology, Vol. 14, No. 6, Juni 1996, Seiten 1136 - 1143 eine Frequenzregelung von Lasern in dem 1,3 und 1,55 µm Band beschrieben. Ein Michelson-Interferometer wird durch einen Master-Laser geeicht. Dieser Interferometer liefert eine Gruppe von Differenzfrequenzen mit gleichem Abstand, die durch Phasenregelschleifen konstant gehalten werden. In dieser Literaturstelle auch wird ein weitere Methode beschrieben, die eine höhere Flexibilität bei der Erzeugung der Referenzfrequenzen zuläßt.

Aus der Patentschrift US4,926,429 ist ein Lichtwellenleiter-Übertragungssystem bekannt, bei dem die Frequenzen von optischen Signalen sende- und empfangsseitig durch Regelschleifen mit Gaselementen und optogalvanischen Elementen konstant gehalten werden.

Verschiedene hochgenaue optische Oszillatoren werden in "Short and Long Term Stability of Optical Oscillators" von M. Zhu und J.L. Hall, 1992 IEEE Frequenzy Control Symposium, Hershey, Pennsylvania, USA, Seite 45 - 55 untersucht.

In "Absolute heterodyne frequency measurement of the ⁸⁸Sr+ 455-THz S-D single ion transition", Optics Letters, Vol. 21, No. 11, 1. Juni 1996, Seite 824 - 826 wird lediglich eine genaue Frequenz-Meßmethode angegeben.

All diese Verfahren und Einrichtungen erscheinen für die Erzeugung einer einzigen Referenzfrequenz bei extrem hohen Frequenzen als ungeeignet, da sie zu aufwendig sind.

Die Aufgabe bei der vorliegenden Erfindung besteht also darin, eine Einrichtung zur Frequenzreferenz zu schaffen, die ein Referenzsignal erzeugt, daß im ITU-Frequenzraster liegt.

Die Aufgabe wird durch ein Verfahren und eine Anordnung der eingangs genannten Art gelöst.

Der besondere Vorteil des erfindungsgemäßen Verfahrens liegt darin, daß bei dessen Realisierung einer erfindungsgemäßen Anordnung nur wenige Bauteile im Mikrowellenbereich betrieben werden, während der größere Teil nur von einem Signal mit einer deutlich niedrigeren Frequenz durchlaufen wird. Bevorzugte Aus- und Weiterbildungen der Erfindung sind in den Patentansprüchen 2 und 4 bis 6 beschrieben.

Die Erfindung soll im folgenden anhand eines Ausführungsbeispieles näher erläutert werden.

Dabei zeigt:

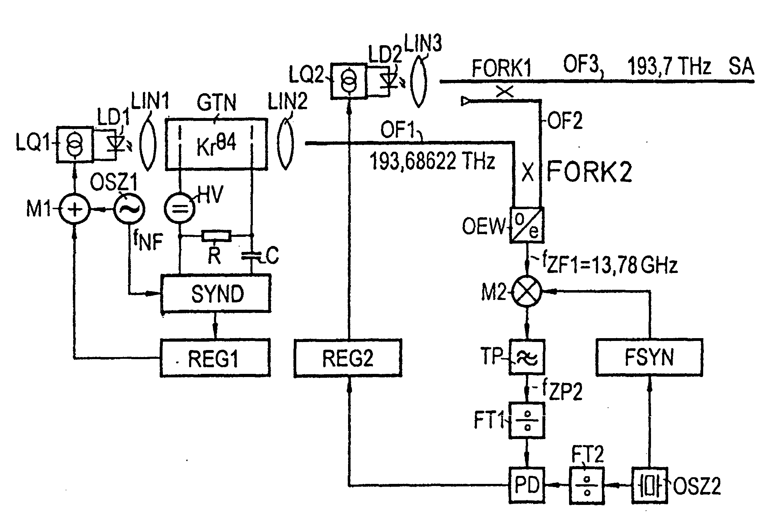

- Figur 1: eine Anordnung zur Erzeugung eines Frequenzreferenzsignals bei einer Frequenz von 193,7 THz die im empfohlenen Frequenzraster der ITU-T liegt.

Die in der Figur 1 dargestellte Anordnung zur Erzeugung eines Frequenzreferenzsignals besteht aus einem linken, an sich bekannten Teil mit einer ersten Laserdiode LD1, einem Galvanotron GTN und einer angeschlossenen Regeleinrichtung sowie einem rechten Teil, in dem aus dem Ausgangslicht des Galvanotrons ein im von der ITU-T empfohlenen Frequenzkanalraster liegendes Frequenzreferenzsignal erzeugt wird.

Im linken Teil ist an eine erste Laserdiodenstromquelle LQ1 eine erste Laserdiode LD1 angeschlossen, deren Ausgangslicht über eine erste Linse LIN1 kollimiert, in ein mit dem Kryptonisotop Kr⁸⁴ gefülltes Galvanotron eingekoppelt wird. Anstelle des Kryptonisotopes können auch in bekannter Weise Ammoniak, Azetylen, Blausäure oder andere Stoffe verwendet werden. Von einem ersten Oszillator OSZ1 wird ein im Bereich von 1 bis hundert Kiloherz liegendes und damit vergleichsweise niederfrequentes Signal erzeugt und an einen Synchrondetektor SYND sowie an einen Addierer M1 abgegeben, in dem das niederfrequente Signal einem von einem ersten Regler REG1 erzeugten Regelsignal überlagert und an die erste Laserstromquelle LQ1 abgegeben wird. Die niederfrequente Schwingung tritt dann im Licht der ersten Laserdiode LD1 und auch an den Anschlüssen des Galvanotrons GTN auf, wobei die Anschlüsse direkt bzw. über einen Widerstand R mit einer Hochspannungsquelle und außerdem über die Hochspannungsquelle und einen Kondensator C mit Signaleingängen des Synchrondetektors SYND verbunden sind. Der Ausgang des Synchrondetektors SYND ist mit einem Eingang des ersten Reglers REG1 verbunden, so daß sich insgesamt eine Regelschleife ergibt. Das an den Galvanotronanschlüssen anstehende synchrone Signal, das mittels Synchrondetektion detektiert wird, dient zur Nachregelung der Emissionsfrequenz der ersten Laserdioden LD1 auf den Wert des atomaren Überganges des Kryptonisotops Kr⁸⁴, so daß am Ausgang des Galvanotrons GTN über eine zweite Linse LIN2 ein Lichtsignal in eine angekoppelte erste optische Faser OF1 geleitet wird, das ein Referenzsignal mit der Frequenz 193,68622 THz darstellt. Von diesem ersten Referenzsignal ausgehend wird in den anschließenden Baugruppen ein zweites Referenzsignal erzeugt.

Zur Erzeugung des in das Kanalraster der ITU-T frequenzmäßig passenden zweiten Frequenzreferenzsignals aus dem ersten Frequenzreferenzsignal ist eine zweite Laserdiode LD2 vorgesehen, die von einer zweiten Laserstromquelle LQ2 gespeist wird und über eine dritte Linse LIN3 ihr Licht an den einen Eingang eines ersten faseroptischen Richtkopplers FORK1 und über eine dritte optische Faser OF3 an einen Signalausgang SA abgibt. Der zweite Eingang des ersten faseroptischen Richtkopplers FORK1 bleibt frei, während der zweite Ausgang über eine zweite optische Faser OF2 mit den zweiten Eingang eines zweiten faseroptischen Richtkopplers verbunden ist. Der erste Eingang dieses zweiten faseroptischen Richtkopplers FORK2 ist an die zweite Linse LIN2 angekoppelt und übernimmt dadurch das vom Galvanotron GTN stammende Licht, das das erste Frequenzreferenzsignal darstellt. Im zweiten faseroptischen Richtkoppler FORK2 erfolgt eine Überlagerung der von der ersten und der zweiten Laserdiode LD1, LD2 stammende Lichtwellen, wobei die Differenzfrequenz zwischen der Frequenz des Lichts der ersten Laserdiode von 193,68622 THz und dem Licht der zweiten Laserdiode mit einer Frequenz von 193,7 THz ein Mikrowellensignal mit einer Frequenz von 13,78 GHz darstellt, das bei Zuführung beider Lichtstrahlen zu einem optoelektronischen Wandler OEW von diesem an den einen Eingang eines Modulators M2 abgegeben wird.

Um Probleme mit Polarisationsschwankungen zu vermeiden, bzw. um die Wandler einfach zu halten, also ohne einen Polarisationsdiversitätsempfänger auszukommen, sind die verwendeten optischen Fasern OF1, OF2, OF3 vorzugsweise polarisationserhaltend.

Mit dem zweiten Eingang des Modulators M2 ist der Ausgang eines Frequenzsynthesizers FSYN verbunden, der von einem Quarzoszillator OSZ2 ein Grundsignal erhält und aus diesem ein Mikrowellensignal erzeugt, das mit dem Ausgangssignal des optoelektronsichen Wandlers OEW, also mit dem ersten Zwischenfrequenzsignal gemischt wird. Das Ausgangssignal des Modulators bzw. Mischers M2 gelangt über einen Tiefpaß TP und einen nachgeschalteten ersten Frequenzteiler FT1 zum einen Eingang eines Phasendetektors PD, an dessen anderen Eingang der Ausgang eines zweiten Frequenzteilers FT2 angeschlossen ist, der das Ausgangssignal des Quarzoszillators OSZ2 herunterteilt. Im Phasendetektor PD erfolgt ein Phasenvergleich zwischen dem vom Mischer M2 erzeugten zweiten Frequenzdifferenzsignal und dem Ausgangssignal des zweiten Frequenzteilers FT2 als weiterem Referenzsignal. Erster und zweiter Frequenzteiler FT1, FT2 weisen einen vergleichsweise hohen Teilerfaktor auf, der neben der leichteren Verarbeitung des Ausgangssignals das bei Laserdioden übliche starke Phasenrauschen ausmittelt. Mit dem Ausgang des Phasendetektors PD ist der Eingang eines zweiten Reglers REG2 verbunden, der ein Regelsignal für die zweite Laserstromversorgung LQ1 und damit für die zweite Laserdiode LD2 erzeugt. Das am Ausgang des Phasendetektors PD anliegende Fehlersignal wird dabei im Regler so umgewandelt, daß die Emissionsfrequenz der zweiten Laserdiode LD2 entsprechend nachgeführt wird und diese ein zweites Frequenzreferenzsignal mit der Genauigkeit des atomaren Übergangs des im Galvanotron GTN verwendeten Gases, bei gleichwertiger Lage im von der ITU empfohlenen Kanalraster erzeugt.

Für die erste und die zweite Laserdiode LD1, LD2 wurden DFB-Laser verwendet, Maßnahmen zum Gewährleistung eines störungsfreien Betriebes der Laserdioden, wie beispielsweise optische Isolatoren und Temperaturstabilisierungen sind im Bild 1 der Übersichtlichkeit halber weggelassen.

## Patentansprüche

1. Verfahren zur Erzeugung eines optischen Frequenzreferenzsignals insbesondere für Wellenlängenvielfachbetrieb, bei dem mittels einer ersten Laserdiode ein erstes optisches Signal erzeugt wird, dem ein niederfrequentes Signal kleiner Amplitude überlagert ist und das erste optische Signal durch ein gasgefülltes Galvanotron geleitet wird und dabei an den Anschlüssen des Galvanotrons das niederfrequente Signal auftritt, das einem Synchrondetektor zugeführt wird, der ein Ausgangssignal zur Erzeugung eines Regelsignals abgibt, das zusammen mit dem ursprünglichen niederfrequenten Signal kombiniert zur-Regelung der ersten Laserdiode dient und bei dem das das Galvanotron durchlaufende optische Signal ein erstes Frequenzreferenzsignal darstellt,
**dadurch gekennzeichnet,**
**daß** eine zweite Laserdiode ein zweites optisches Signal erzeugt, das mittels eines ersten faseroptischen Richtkopplers (FORK1) an den Signalausgang (SA) sowie an einen zweiten faseroptischen Richtkoppler (FORK2) abgegeben und dort mit dem ersten Frequenzreferenzsignal kombiniert wird und dabei ein Mikrowellensignal erzeugt wird, das nach optoelektrischer Wandlung einer Frequenzregelschleife zugeführt und dort mit einem quarzgestützten Frequenzsynthesizersignal zur Erzeugung eines zweiten Differenzsignals mit niedrigerer Frequenz gemischt wird, daß das Signal des Quarzoszillators und das zweite Differenzsignal jeweils nach Frequenzteilung einem Phasenvergleich unterworfen werden und das sich ergebende Ausgangssignal zur Erzeugung eines Regelsignals für die zweite Laserdiode (LD2) dient.

2. Verfahren nach Anspruch 1,
**dadurch gekennzeichnet,**
**daß** der Arbeitspunkt der zweiten Laserdiode so eingeregelt wird, daß ein im vorgewählten Frequenzkanalraster liegendes optisches Signal erzeugt wird, das bei der Mischung mit dem ersten Frequenzreferenzsignal zum Auftreten eines Mikrowellensignals führt und daß ein zweites Mikrowellensignal erzeugt wird, daß vom ersten Mikrowellensignal nur um wenige 100 MHz abweicht.

3. Anordnung zur Durchführung eines Verfahrens nach Ansprüchen 1 oder 2 mit einer an eine erste Laserstromquelle (LQ1) angeschlossenen ersten Laserdiode (LD1) an die sich im Lichtweg eine erste Linse (LIN1), ein vorzugsweise mit dem Kryptonisotop Kr⁸⁴ gefülltes Galvanotron (GTN) und an dieses eine zweite Linse (LIN2) anschließen, daß das Galvanotron (GTN) einerseits direkt und andererseits über einen widerstand (R) mit einer Hochspannungsquelle (HV) verbunden ist, daß ein Anschluß des Widerstandes (R) direkt und der andere über einen Koppelkondensator (C) mit zugeordneten Eingangsanschlüssen eines Synchrondetektors (SYND) verbunden ist, dessen Ausgangsanschluß mit dem Eingangsanschluß eines ersten Reglers (REG1) und dessen Ausgangsanschluß mit einem Signaleingang eines Addierers (M1) verbunden ist, daß ein erster Oszillator (OSZ1) zur Erzeugung eines niederfrequenten Signals kleiner Amplitude vorgesehen ist und dieses Signal an einen zugeordneten Eingang des Synchrondetektors (SYND) sowie eines zweiten Einganges des Addierers (M1) abgegeben wird und dessen Ausgang mit einem Regeleingang der ersten Laserstromversorgung (LQ1) verbunden ist,
**dadurch gekennzeichnet,**
**daß** eine an einer zweite Laserstromversorgung (LQ2) angeschlossene zweite Laserdiode (LD2) vorgesehen ist, deren Ausgangslicht über eine dritte Linse (LIN3) einem ersten Eingang eines ersten faseroptischen Richtkopplers (FORK1) zugeführt ist, daß der zweite Eingang des ersten faseroptischen Richtkopplers (FORK1) offen bleibt, der erste Ausgang über eine dritte optische Faser (OF3) mit einem Signalausgang (SA) verbunden ist und der zweite Ausgang über eine zweite optische Faser (OF2) mit dem zweiten Eingang eines zweiten faseroptischen Richtkopplers (FORK2) verbunden ist, dessen erster Eingang über eine erste optische Faser (OF1) an die zweite Linse (LIN2) angekoppelt ist, daß die Ausgänge des zweiten faseroptischen Richtkopplers (FORK2) mit Eingängen eines optoelektronischen Wandlers (OEW) verbunden sind und dessen Ausgang mit einem Signaleingang eines Modulators (M2) verbunden ist, dessen zweiter Signaleingang mit einem Ausgang eines ein Mikrowellensignal erzeugenden Frequenzsynthesizers verbunden ist, dessen Signaleingang an den Ausgang eines Quarzoszillators (OSZ2) angeschlossen ist, daß der Ausgang des Modulators (M2) über einen Tiefpaßfilter (TP) mit einem Signaleingang eines ersten Frequenzteilers (FT1) verbunden ist, daß dessen Ausgang mit dem einen Eingang eines Phasendetektors (PD) verbunden ist, daß ein zweiter Frequenzteiler (FT2) vorgesehen ist, dessen Signaleingang mit einem Ausgang des Quarzoszillators (OSZ2) und dessen Ausgang mit einem weiteren Eingang des Phasendiskriminators (PD) verbunden ist, dessen Ausgang mit einem Eingang eines zweiten Reglers (REG2) verbunden ist und dessen Ausgang an einen Regeleingang der zweiten Laserstromversorgung (LQ2) angeschlossen ist.

4. Anordnung nach Anspruch 3,
**dadurch gekennzeichnet,**
**daß** die Verbindungen zu den und von den faseroptischen Frequenzreferenz (FORK1, FORK2) mittels polarisationserhaltender optischer Fasern (OF1, OF2, OF3) erfolgt.

5. Anordnung nach Anspruch 3,
**dadurch gekennzeichnet,**
**daß** es sich bei der ersten und der zweiten Laserdiode (LD1, LD2) um DFB-Laser handelt.

## Claims

1. Method for generating an optical frequency reference signal, especially for wavelength division multiplexing, in which a first optical signal is generated by means of a first laser diode, onto which a lower-frequency signal of smaller amplitude is overlaid and the first optical signal is fed through a gas-filled galvanotron and when this is done the lower-frequency signal occurs at the terminals of the galvanotron which is routed to a synchronous detector which emits an output signal to generate a control signal which, combined together with the original low-frequency signal, is used for regulating the first laser diode and for which the optical signal passing through the galvanotron represents a first frequency reference signal,
**characterized in that**,
a second laser diode generates a second optical signal which is emitted by means of a first fiber optic directional coupler (FORK1) to the signal output (SA) as well as two a second fiber optic directional coupler FORK2) and is combined there with a first frequency reference signal and thereby a microwave signal is generated, which after optoelectrical conversion is fed to a frequency control loop and is mixed there with a quartz-based frequency synthesizer signal to generate a second differential signal with lower frequency, that the signal of the quartz oscillations and the second differential signal are each subjected after frequency division to a phase comparison and the resulting output signal serves to generate a control signal for the second laser diode (LD2).

2. Method in accordance with Claim 1,
**characterized in that**,
the operating point of the second laser diode is regulated in such a way that an optical signal lying within a preselected frequency channel spacing is created, which on mixing with the first frequency reference signal leads to the occurrence of a microwave signal and that a second microwave signal is generated which only deviates from the first microwave signal by a few 100 MHz.

3. Arrangement to execute a method in accordance with Claims 1 or 2, with a first laser diode (LD1) connected to a first laser power source (LQ1) to which in the light path a first lens (LIN1), a galvanotron (GTN) preferably filled with the krypton isotope Kr⁸⁴and to this a second lens (LINZ) are connected , that the galvanotron (GTN) is connected on the one side directly and on the other side via a resistor (R) with a high-voltage source (HV), that one terminal of the resistor (R) is connected directly and the other via a coupling capacitor (C) with assigned input terminals of a synchronous detector (SYND), the output terminal of which is connected with the input terminal of a first regulator (REG1) and the output terminal of which is connected to the signal input of an adder (M1), that a first oscillator (OSZ1) is provided to create a lower-frequency signals of small amplitude and this signal is emitted to an assigned input of the synchronous detector (SYND) as well as a second input of the adder (M1) and the output of which is connected to the control input of the first laser power supply (LQ1),
**characterized in that**,
a second laser diode (LD2) connected to a second laser power supply (LQ2) is provided, of which the output light is fed via a third lens (LIN3) to a first input of a first fiber optic directional coupler (FORK1), that the second input of the first fiber optic directional coupler (FORK1) remains open, the first output is connected via a third optical fiber (OF3) with a signal output (SA) and the second output via a second optical fiber (OF2) to the second input of a second fiber optic directional coupler (FORK2), the first input of which is coupled via a first optical fiber (OF1) to the second lens (LIN2), that the outputs of the second fiber optic directional coupler (FORK2) are connected to inputs of an optoelectronic converter (OEW) and the output of which is connected to the signal input of a modulator (M2), the second signal input of which is connected to one output of a frequency synthesizer generating a microwave signal, the signal input of which is connected to the output of a quartz oscillators (OSZ2), that the output of the modulator (M2) is linked via a lowpass filter (TP) to a signal input of a first frequency divider (FT1), that its output is connected to the input of a phase detector (PD), that a second frequency divider (FT2) is provided, of which the signal input is connected to one output of the quartz oscillator (OSZ2) and the output of which is connected to a further input of the phase discriminator (PD), the output is which is connected to the input of a second regulator (REG2) and that output of which is connected to a control input of the second laser power supply (LQ2).

4. Arrangement according to Claim 3,
**characterized in that**
the connections to the and from the fiber optic frequency reference (FORK1, FORK2) are made via polarization-retaining optical fibers (OF1, OF2, OF3)

5. Arrangement according to Claim 3,
**characterized in that**
the first and second laser diodes (LD1, LD2) are DFB lasers.

## Revendications

1. Procédé permettant de générer un signal optique de référence de fréquence, notamment, pour le fonctionnement en multiplexage de longueurs d'ondes, dans lequel, au moyen d'une première diode laser, on génère un premier signal optique, sur lequel est superposé un signal basse fréquence de petite amplitude et dans lequel le premier signal optique est envoyé à travers un galvanotron rempli de gaz et, en même temps, apparaît aux bornes du galvanotron le signal basse fréquence qui est appliqué à un démodulateur synchrone délivrant un signal de sortie destiné à produire un signal de régulation, lequel sert, combiné en commun avec le signal basse fréquence d'origine, à régler la première diode laser, et dans lequel le signal optique qui traverse le galvanotron constitue un premier signal de référence de fréquence,
**caractérisé par le fait**
**qu'**une deuxième diode laser produit un deuxième signal optique, qui est délivré, au moyen d'un premier coupleur optique (FORK1) à fibre optique, à la sortie de signal (SA), ainsi qu'à un deuxième coupleur optique (FORK2) à fibre optique où il est combiné au premier signal de référence de fréquence, ce qui génère un signal micro-onde qui est, après une conversion opto-électrique, appliqué à une boucle de régulation de fréquence où il est mélangé à un signal de synthétiseur de fréquence commandé par quartz pour produire un deuxième signal différentiel ayant une fréquence plus basse, que le signal de l'oscillateur à quartz et le deuxième signal différentiel sont soumis, chacun après une division de fréquence, à une comparaison de phase et le signal de sortie, qui en résulte, sert à produire un signal de régulation pour la deuxième diode laser (LD2).

2. Procédé selon la revendication 1
**caractérisé par le fait**
**que** le point de fonctionnement de la deuxième diode laser est réglé de telle sorte qu'un signal optique se trouvant dans la grille de canaux de fréquence présélectionnée est produit, lequel, lors du mélange avec le premier signal de référence de fréquence, conduit à l'apparition d'un signal micro-onde et qu'un deuxième signal micro-onde est généré, lequel ne diffère du premier signal micro-onde que de quelques centaines de MHz.

3. Dispositif destiné à l'exécution du procédé selon les revendications 1 ou 2, comportant une première diode laser (LD1) raccordée à une première source de courant laser (LQ1) et suivie, sur le parcours de la lumière, d'une première lentille (LIN1), d'un galvanotron (GTN) rempli préférentiellement avec de l'isotope de krypton Kr⁸⁴ et, derrière celui-ci, d'une deuxième lentille (LIN2), le galvanotron (GTN) étant raccordé, d'une part directement et, d'autre part, par l'intermédiaire d'une résistance (R), à une source de haute tension (HV), une borne de la résistance (R) étant raccordée directement et l'autre borne par l'intermédiaire d'un condensateur de couplage (C) aux bornes d'entrée correspondantes d'un démodulateur synchrone (SYND), dont la sortie est raccordée à l'entrée d'un premier régulateur (REG1) dont la sortie est raccordée à l'entrée de signal d'un additionneur (M1), un premier oscillateur (OSZ1) étant prévu pour produire un signal basse fréquence de faible amplitude et ce signal étant appliqué à une entrée correspondante du démodulateur synchrone (SYND), ainsi qu'à la deuxième entrée de l'additionneur (M1) dont la sortie est raccordée à une entrée de régulation de la première alimentation en courant laser (LQ1),
**caractérisé par le fait**
**qu'**il est prévu une deuxième diode laser (LD2) raccordée à une deuxième alimentation en courant laser (LQ2), la lumière de sortie de cette deuxième diode laser (LD2) étant guidée, par l'intermédiaire d'une troisième lentille (LIN3), sur une première entrée d'un premier coupleur directif (FORK1) à fibre optique, que la deuxième entrée du premier coupleur directif (FORK1) à fibre optique reste inoccupée, que la première sortie est raccordée, par l'intermédiaire d'une troisième fibre optique (OF3), à une sortie de signal (SA) et que la deuxième sortie est raccordée, par l'intermédiaire d'une deuxième fibre optique (OF2), à la deuxième entrée d'un deuxième coupleur directif (FORK2) à fibre optique, dont la première entrée est couplée, par l'intermédiaire d'une première fibre optique (OF1), à la deuxième lentille (LIN2), que les sorties du deuxième coupleur directif (FORK2) à fibre optique sont raccordées à des entrées d'un convertisseur opto-électronique (OEW), dont la sortie est raccordée à une entrée de signal d'un modulateur (M2) dont la deuxième entrée de signal est raccordée à une sortie d'un synthétiseur de fréquence produisant un signal micro-onde, dont l'entrée de signal est raccordée à la sortie d'un oscillateur à quartz (OSZ2), que la sortie du modulateur (M2) est raccordée, à travers un filtre passe-bas (TP), à une entrée de signal d'un premier diviseur de fréquence (FT1), que la sortie de ce dernier est raccordée à l'une des entrées d'un démodulateur de phase (PD), qu'il est prévu un deuxième diviseur de fréquence (FT2) dont l'entrée de signal est raccordée à une sortie de l'oscillateur à quartz (OSZ2) et dont la sortie est raccordée à une autre entrée du discriminateur de phase (PD), dont la sortie est raccordée à une entrée d'un deuxième régulateur (REG2) dont la sortie est raccordée à une entrée de régulation de la deuxième alimentation en courant laser (LQ2).

4. Dispositif selon la revendication 3
**caractérisé par le fait**
**que** les liaisons allant vers les coupleurs directifs (FORK1, FORK2) à fibre optique et partant des coupleurs directifs (FORK1, FORK2) à fibre optique sont réalisées au moyen de fibres optiques (OF1, OF2, OF3) conservant la polarisation.

5. Dispositif selon la revendication 3
**caractérisé par le fait**
**que** la première et la deuxième diode laser (LD1, LD2) sont des lasers DFB (pour "distributed feedback" en anglais).
